# EUROPÄISCHE PATENTANMELDUNG

(11) **EP 1 528 596 A1**
(43) Veröffentlichungstag der Anmeldung: **04.05.2005**
(21) Anmeldenummer: 03405766.1
(22) Anmeldetag: 27.10.2003
(51) Int. Cl.: H01L 25/11

(54) **Haltevorrichtung für mindestens einen Halbleiterstapelverband sowie ein elektrisches System mit solchen Haltevorrichtungen**

(71) Anmelder: ABB Schweiz AG, 5400 Baden (CH)
(72) Erfinder: Sax, Daniel, 5300 Turgi (CH); Boban, Ivo, 5400 Baden (CH)
(74) Vertreter: ABB Patent Attorneys

(57) **Zusammenfassung**

Es wird eine Haltevorrichtung für mindestens einen Halbleiterstapelverband (1) angegeben, die aus einem Deckenteil (2), einem Bodenteil (3) und einem ersten Seitenteil (4) und einem zweiten Seitenteil (5) aufgebaut ist, wobei der Deckenteil (2) über das erste und zweite Seitenteil (4, 5) mit dem Bodenteil (3) verbindbar ausgebildet ist und der oder jeder Halbleiterstapelverband (1) zwischen dem Deckenteil (2) und dem Bodenteil (3) eingespannt ist. Zur weitestgehenden Vermeidung von Teilentladungen am Halbleiterstapelverband und/oder an der Haltevorrichtung ist das erste Seitenteil (4) und das zweite Seitenteil (5) jeweils berührungslos von dem oder jedem Halbleiterstapelverband (1) beabstandet.

## Beschreibung

### Technisches Gebiet

Die vorliegende Erfindung bezieht sich auf das Gebiet der Befestigungstechnik elektronischer und leistungselektronischer Bauelemente. Sie betrifft eine Haltevorrichtung für mindestens einen Halbleiterstapelverband sowie ein elektrisches System mit mindestens zwei solcher Haltevorrichtungen gemäss dem Oberbegriff der unabhängigen Ansprüche.

### Stand der Technik

Elektronische Bauelemente, vor allem Leistungshalbleiterschalter, werden heute in einer Fülle von leistungselektronischen Schaltungen, insbesondere in Umrichterschaltungen, eingesetzt. Zur Schaltung hoher Spannungen werden üblicherweise Serienschaltungen solcher Leistungshalbleiterschalter verwendet, die als Halbleiterstapelverband ausgebildet sind. Zur Befestigung eines solchen Halbleiterstapelverbandes, beispielsweise in einem Schaltschrank, werden gängigerweise Haltevorrichtungen eingesetzt. Eine solche Haltevorrichtung für mindestens einen Halbleiterstapelverband ist beispielsweise in der DE 199 37 671 A1 offenbart. Darin ist die Haltevorrichtung aus einem Deckenteil, einem Bodenteil und einem ersten Seitenteil und einem zweiten Seitenteil aufgebaut, wobei der Deckenteil über das erste und zweite Seitenteil mit dem Bodenteil verbindbar ausgebildet ist und der oder jeder Halbleiterstapelverband zwischen dem Deckenteil und dem Bodenteil eingespannt ist. Desweiteren sind metallische Führungselemente am Halbleiterstapelverband, insbesondere an den Kühlkörpern der einzelnen Leistungshalbleiter des Halbleiterstapelverbandes vorgesehen, mit welchen der Halbleiterstapelverband an den beiden Seitenteilen geführt ist.

Problematisch bei einer derartigen Haltevorrichtung nach der DE 199 37 671 A1 ist, dass es durch die Führung des Halbleiterstapelverbandes am ersten und am zweiten Seitenteil, d.h. durch Berührung des Halbleiterstapelverbandes mit dem ersten und zweiten Seitenteil, zu Teilentladungen, insbesondere während des Betriebs des Halbleiterstapelverbandes beispielsweise in einer Umrichterschaltung, an den beiden Seitenteilen und am Halbleiterstapelverband selbst kommen kann, wodurch die beiden Seitenteile beschädigt beziehungsweise die Leistungshalbleiterschalter des Halbleiterstapelverbandes beschädigt oder gar zerstört werden können. Ein einwandfreier Betrieb einer Umrichterschaltung mit einer vorstehend beschriebenen Haltevorrichtung für einen entsprechenden Halbleiterstapelverband der Umrichterschaltung ist dann nicht mehr gewährleistet.

### Darstellung der Erfindung

Aufgabe der Erfindung ist es deshalb, eine Haltevorrichtung für mindestens einen Halbleiterstapelverband anzugeben, bei der Teilentladungen am Halbleiterstapelverband und/oder an der Haltevorrichtung weitestgehend vermieden werden können. Ferner ist ein elektrisches System anzugeben, welches mindestens zwei erfindungsgemässen Haltevorrichtungen umfasst und einen platzsparenden Aufbau aufweist sowie nahezu keine Teilentladungen oder nur in sehr geringer Anzahl an den Halbleiterstapelverbänden und/oder an den Haltevorrichtungen bei gleichzeitig hohen Schaltströmen beziehungsweise hohen Schaltspannungen aufweist. Diese Aufgaben werden durch die Merkmale des Anspruchs 1, 8 und 9 gelöst. In den abhängigen Ansprüchen sind vorteilhafte Weiterbildungen der Erfindung angegeben.

Die erfindungsgemässe Haltevorrichtung für mindestens einen Halbleiterstapelverband ist aus einem Deckenteil, einem Bodenteil und einem ersten Seitenteil und einem zweiten Seitenteil aufgebaut, wobei der Deckenteil über das erste und zweite Seitenteil mit dem Bodenteil verbindbar ausgebildet und der oder jeder Halbleiterstapelverband zwischen dem Deckenteil und dem Bodenteil eingespannt ist. Erfindungsgemäss ist das erste Seitenteil und das zweite Seitenteil jeweils berührungslos von dem oder jedem Halbleiterstapelverband beabstandet. Durch die berührungslose Beabstandung des ersten und zweiten Seitenteils jeweils von dem oder jedem Halbleiterstapelverband ist vorteilhaft erreicht, dass Teilentladungen am ersten Seitenteil und/oder am zweiten Seitenteil und/oder am entsprechenden Halbleiterstapelverband, insbesondere während des Betriebs des jeweiligen Halbleiterstapelverbandes beispielsweise in einer Umrichterschaltung, sehr stark reduziert und damit weitestgehend vermieden werden, da keine wie aus dem Stand der Technik bekannte Berührung eines der Seitenteile oder beider Seitenteile mit dem Halbleiterstapelverband vorliegt. Durch die annähernde Vermeidung von Teilentladungen sind die beiden Seitenteile beziehungsweise die Leistungshalbleiterschalter des zugehörigen Halbleiterstapelverbandes zudem vorteilhaft vor Beschädigung oder Zerstörung geschützt.

Das erfindungsgemässe elektrische System weist mindestens zwei erfindungsgemässe Haltevorrichtungen, wobei die Haltevorrichtungen nebeneinander oder übereinander angeordnet sind. Durch das erfindungsgemässe elektrische System mit einer Anordnung der Haltevorrichtungen nebeneinander kann vorteilhaft erreicht werden, dass sehr hohe Schaltströme, insbesondere bei Parallelschaltung sämtlicher Halbleiterstapelverbände, bei gleichzeitig fast keinem oder nur sehr geringem Auftreten von Teilentladungen an den Halbleiterstapelverbänden und/oder an den Haltevorrichtungen erzielbar sind. Darüber hinaus kann durch das erfindungsgemässe elektrische System mit einer Anordnung der Haltevorrichtungen übereinander vorteilhaft erreicht werden, dass sehr hohe Schaltspannungen, insbesondere bei Serieschaltung sämtlicher Halbleiterstapelverbände, bei gleichzeitig fast keinem oder nur sehr geringem Auftreten von Teilentladungen an den Halbleiterstapelverbänden und/oder an den Haltevorrichtungen erzielbar sind. Zudem ist durch die Anordnung der Haltevorrichtungen nebeneinander oder übereinander ein sehr platzsparender Aufbau des erfindungsgemässen elektrischen Systems erreicht.

Diese und weitere Aufgaben, Vorteile und Merkmale der vorliegenden Erfindung werden aus der nachfolgenden detaillierten Beschreibung bevorzugter Ausführungsbeispiele der Erfindung in Verbindung mit der Zeichnung offensichtlich.

### Kurze Beschreibung der Zeichnung

Es zeigen:
- Fig. 1: eine räumliche Darstellung einer ersten Ausführungsform einer erfindungsgemässen Haltevorrichtung,
- Fig. 2: eine räumliche Darstellung einer zweiten Ausführungsform der erfindungsgemässen Haltevorrichtung,
- Fig. 3: eine räumliche Darstellung einer ersten Ausführungsform eines erfindungsgemässen elektrischen Systems und
- Fig. 4: eine räumliche Darstellung einer zweiten Ausführungsform des erfindungsgemässen elektrischen Systems.

Die in der Zeichnung verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen. Die beschriebenen Ausführungsformen stehen beispielhaft für den Erfindungsgegenstand und haben keine beschränkende Wirkung.

### Wege zur Ausführung der Erfindung

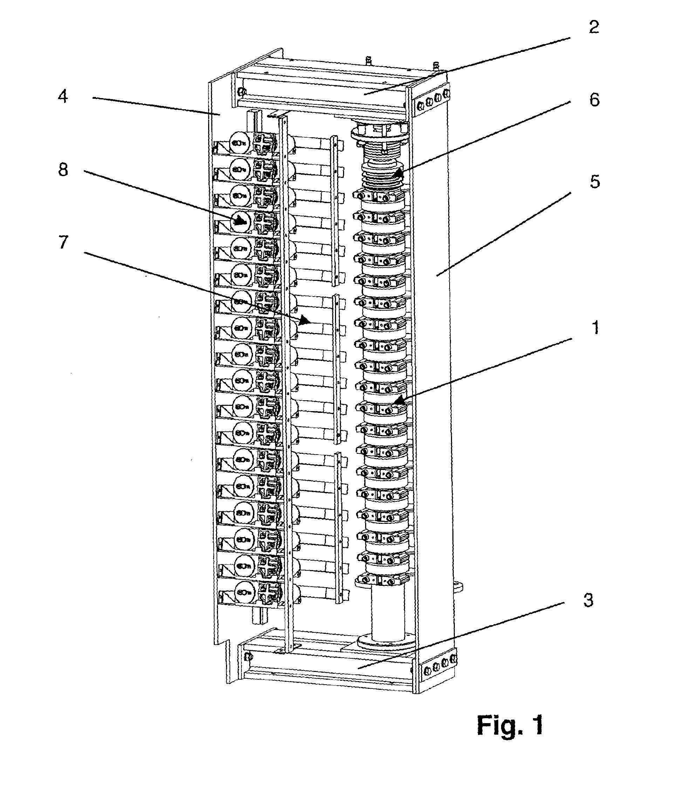

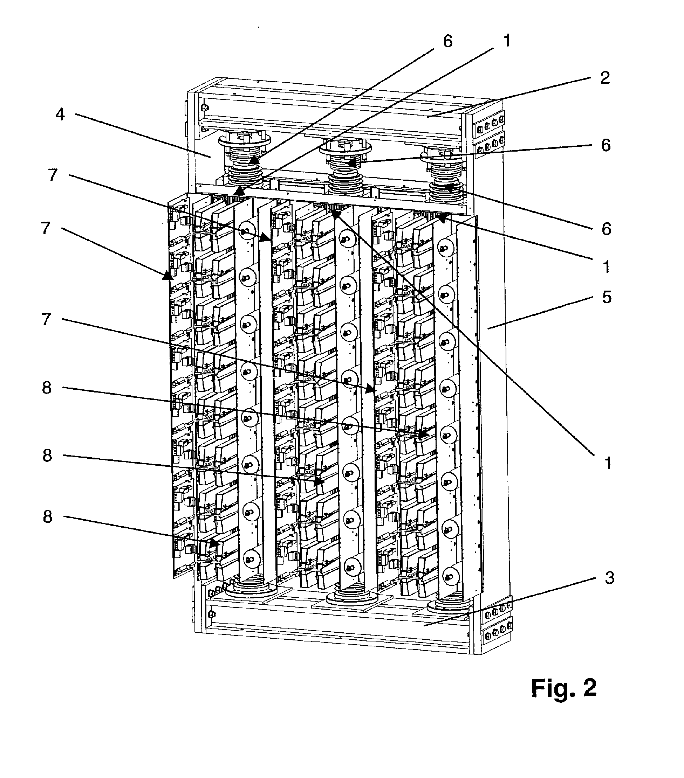

In Fig. 1 ist eine räumliche Darstellung einer ersten Ausführungsform einer erfindungsgemässen Haltevorrichtung für mindestens einen Halbleiterstapelverband dargestellt. Gemäss Fig. 1 ist die erfindungsgemässe Haltevorrichtung aus einem Deckenteil 2, einem Bodenteil 3 und einem ersten Seitenteil 4 und einem zweiten Seitenteil 5 aufgebaut. Der Deckenteil 2 ist über das erste und zweite Seitenteil 4, 5 mit dem Bodenteil 3 verbindbar ausgebildet. Desweiteren ist der oder jeder Halbleiterstapelverband 1 zwischen dem Deckenteil 2 und dem Bodenteil 3 eingespannt. Erfindungsgemäss ist das erste Seitenteil 4 und das zweite Seitenteil 5 jeweils berührungslos von dem Halbleiterstapelverband 1, im Falle nur eines einzigen Halbleiterstapelverbandes 1, oder von jedem Halbleiterstapelverband 1, im Falle mehrerer Halbleiterstapelverbände 1 beabstandet. Dieser letztgenannte Fall, bei dem mehrere Halbleiterstapelverbände 1 zwischen dem Deckenteil 2 und Bodenteil 3 eingespannt sind und das erste Seitenteil 4 und das zweite Seitenteil 5 jeweils von jedem Halbleiterstapelverband 1 berührungslos beabstandet sind, ist in einer räumlichen Darstellung einer zweiten Ausführungsform der erfindungsgemässen Haltevorrichtung gemäss Fig. 2 gezeigt, wobei darin explizit drei Halbleiterstapelverbände 1 vorgesehen sind. Die berührungslose Beabstandung des ersten und zweiten Seitenteils 4, 5 jeweils von dem oder jedem Halbleiterstapelverband 1 bewirkt vorteilhaft, dass Teilentladungen am ersten Seitenteil 4 und/oder am zweiten Seitenteil 5 und/oder am entsprechenden Halbleiterstapelverband 1, insbesondere während des Betriebs des jeweiligen Halbleiterstapelverbandes 1 beispielsweise in einer Umrichterschaltung, sehr stark reduziert und damit weitestgehend vermieden werden. Durch die nahezu gänzliche Vermeidung der vorstehend beschriebenen Teilentladungen sind die beiden Seitenteile 4, 5 beziehungsweise die Leistungshalbleiterschalter des zugehörigen Halbleiterstapelverbandes 1 zudem vorteilhaft vor Beschädigung oder Zerstörung geschützt. Weiterhin kann durch die vorstehend erwähnte Beabstandung eine nahezu unlimitierte Schaltspannung Uₛ am jeweiligen Halbleiterstapelverband 1 anliegen beziehungsweise ein nahezu unlimitierter Schaltstrom geführt werden.

Vorzugsweise ist das erste und zweite Seitenteil 4, 5 gemäss Fig. 1 und Fig. 2 jeweils plattenförmig ausgebildet, so dass ein sehr platzsparender Aufbau der Haltevorrichtung erzielt werden kann. Zudem können die beiden Seitenteile 4, 5 durch deren plattenförmige Ausbildung sehr einfach und kostengünstig hergestellt werden. Weiterhin enthält das erste und zweite Seitenteil 4, 5 ein Isolationsmaterial, so dass die vorstehend erwähnten Teilentladungen am ersten Seitenteil 4 und/oder am zweiten Seitenteil 5 und/oder am entsprechenden Halbleiterstapelverband 1 vorteilhaft weiter reduziert werden können.

Gemäss Fig. 1 und Fig. 2 ist weiterhin eine Ansteuereinheit 7 und eine Beschaltung 8 für den entsprechenden Halbleiterstapelverband 1 vorgesehen, die vorzugsweise an der das Isolationsmaterial enthaltenden ersten Seitenplatte 4 oder an der das Isolationsmaterial enthaltende zweiten Seitenplatte 5 angeordnet ist, wodurch die Ansteuereinheit 7 und die Beschaltung 8 auf sehr einfache Weise gegenüber dem zugehörigen Halbleiterstapelverband 1 isoliert werden kann. Vorzugsweise ist die erste Seitenplatte 4 und/oder die zweite Seitenplatte 5 als Befestigungseinheit zur Befestigung der Ansteuereinheit 7 und/oder der Beschaltung 8 ausgebildet, wodurch die erste beziehungsweise zweite Seitenplatte 4, 5 sehr einfach mit der Ansteuereinheit 7 und/oder der Beschaltung vorgefertigt werden kann und sich spätere Wartungsarbeiten an der gesamten Haltevorrichtung vereinfachen.

Es hat sich als besonders vorteilhaft erwiesen, dass bei einem vorgesehenen Halbleiterstapelverband 1, d.h. falls nur ein einziger Halbleiterstapelverband 1 vorgesehen ist, der Abstand a des ersten Seitenteils 4 zum Halbleiterstapelverband 1 und/oder der Abstand a des zweiten Seitenteils 5 zum Halbleiterstapelverband 1 jeweils derart gewählt ist, dass sich ein möglichst homogenes elektrisches Feld zwischen dem Halbleiterstapelverband 1 und dem ersten beziehungsweise zweiten Seitenteil 4, 5 einstellt. Bei mehreren vorgesehenen Halbleiterstapelverbänden 1 ist der Abstand a des ersten Seitenteils 4 zum dem ersten Seitenteil 4 nächstliegenden Halbleiterstapelverband 1 und/oder der Abstand a des zweiten Seitenteils 5 zum dem zweiten Seitenteil 5 nächstliegenden Halbleiterstapelverband 1 derart gewählt, dass sich ein möglichst homogenes elektrisches Feld zwischen dem jeweiligen Halbleiterstapelverband 1 und dem ersten beziehungsweise zweiten Seitenteil 4, 5 einstellt. Durch die vorstehend beschriebene Wahl des Abstandes a wird vorteilhaft bewirkt, dass die Isolationsfestigkeit zwischen dem ersten beziehungsweise zweiten Seitenteil 4, 5 und dem jeweiligen Halbleiterstapelverband 1 gewährleistet ist und zudem aber durch den Abstand a nicht zu viel Platz verschwendet wird.

Gemäss Fig. 1 und Fig. 2 ist zur Einspannung des jeweiligen Halbleiterstapelverbandes 1 erfindungsgemäss eine Einspanneinrichtung 6 zwischen dem Deckenteil 2 und dem jeweiligen Halbleiterstapelverband 1 angeordnet, welche den jeweiligen Halbleiterstapelverband 1 zwischen dem Deckenteil 2 und dem Bodenteil 3 verspannt und damit die Halbleiter und Kühlkörper des Halbleiterstapelverbandes 1 thermisch und elektrisch kontaktiert. Desweiteren ist der jeweilige Halbleiterstapelverband 1 im eingebauten Zustand durch die vorstehend beschriebene Einspanneinrichtung 6 gegen Verschiebung und Herausfallen geschützt. Vorzugsweise ist die Einspanneinrichtung 6 als Feder ausgebildet.

Durch den einfachen und platzsparenden Aufbau der erfindungsgemässen Haltevorrichtung kann diese beispielsweise auch ohne Schaltschrank und/oder freistehend und/oder aufgehängt eingesetzt werden, so dass sich eine Vielzahl an zusätzlichen Verwendungsmöglichkeiten der erfindungsgemässen Haltevorrichtung auf verschiedensten Einsatzgebieten ergibt.

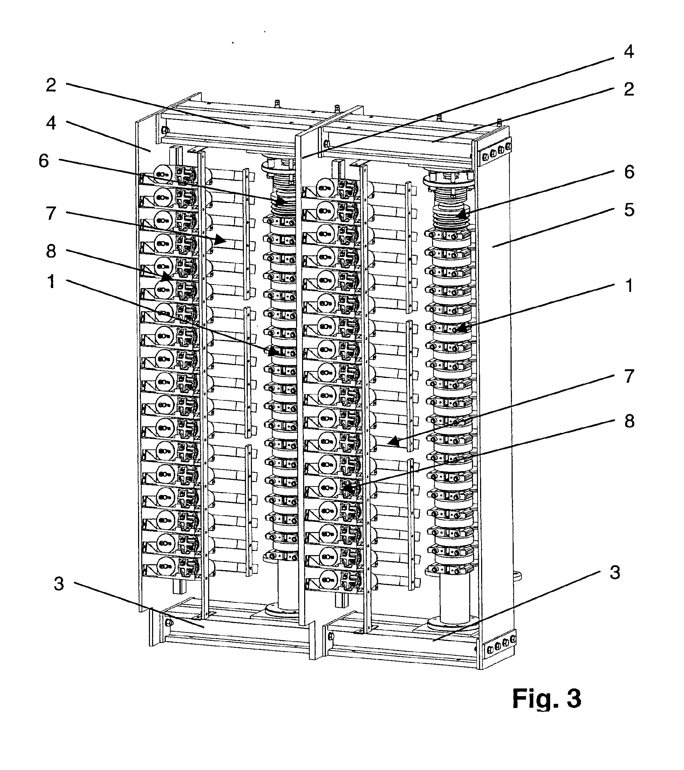

In Fig. 3 ist eine räumliche Darstellung einer ersten Ausführungsform eines erfindungsgemässen elektrischen Systems gezeigt. Darin weist das erfindungsgemässe elektrische System mindestens zwei vorstehend an Hand von Fig. 1 und Fig. 2 beispielhaft beschriebene erfindungsgemässe Haltevorrichtungen, wobei die Haltevorrichtungen nebeneinander angeordnet sind, wobei in Fig. 3 explizit zwei erfindungsgemässe Haltevorrichtungen mit je einem Halbleiterstapelverband 1 dargestellt sind. Durch das erfindungsgemässe elektrische System mit einer Anordnung der Haltevorrichtungen nebeneinander kann vorteilhaft bewirkt werden, dass sehr hohe Schaltströme, insbesondere bei Parallelschaltung sämtlicher Halbleiterstapelverbände 1, bei gleichzeitig fast keinem oder nur sehr geringem Auftreten von Teilentladungen an den Halbleiterstapelverbänden 1 und/oder an den Haltevorrichtungen erreichbar sind. Zudem kann bei den nebeneinander angeordneten Haltevorrichtungen bei jeweils zwei benachbarten Haltevorrichtungen jeweils eines der Seitenteile 4, 5 eingespart werden, so dass jeweils zwei benachbarte Haltevorrichtungen nur noch ein gemeinsames Seitenteil, wie dies in Fig. 3 gezeigt ist, aufweisen.

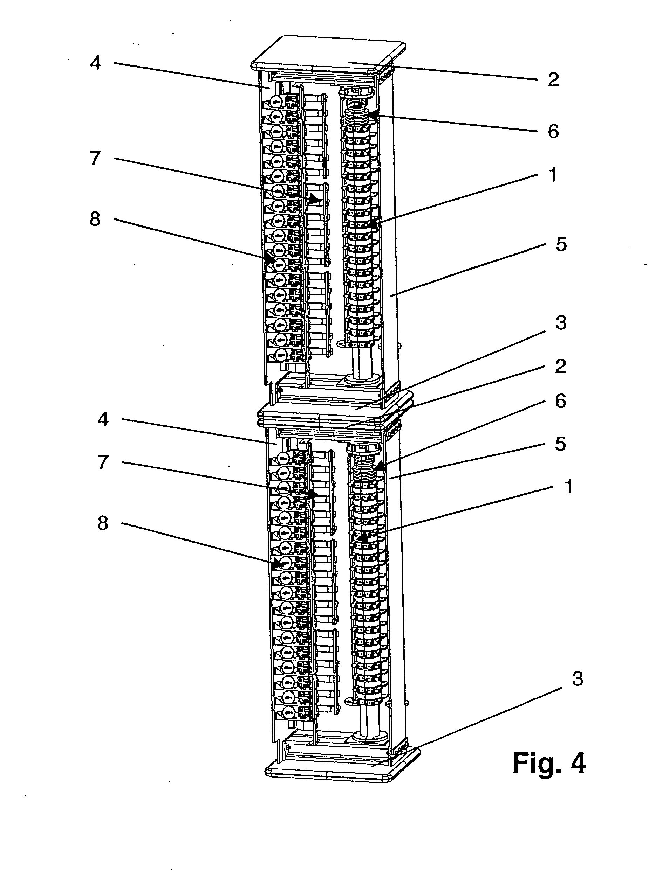

Es ist aber auch denkbar, wie dies in einer räumlichen Darstellung einer zweiten Ausführungsform des erfindungsgemässen elektrischen Systems nach Fig. 4 gezeigt ist, dass mindestens zwei vorstehend an Hand von Fig. 1 und Fig. 2 beispielhaft beschriebene erfindungsgemässe Haltevorrichtungen vorgesehen sind, wobei dann die Haltevorrichtungen im Unterschied zur Ausführungsform gemäss Fig. 3 übereinander angeordnet sind. Mit einer Anordnung der Haltevorrichtungen übereinander kann vorteilhaft erreicht werden, dass sehr hohe Schaltspannungen, insbesondere bei Serieschaltung sämtlicher Halbleiterstapelverbände 1, bei gleichzeitig fast keinem oder nur sehr geringem Auftreten von Teilentladungen an den Halbleiterstapelverbänden 1 und/oder an den Haltevorrichtungen erzielbar sind. Zudem ist durch die Anordnung der Haltevorrichtungen nebeneinander oder übereinander ein sehr platzsparender Aufbau des erfindungsgemässen elektrischen Systems erreicht. Insgesamt ist somit durch die Haltevorrichtungen ein modularer Aufbau des erfindungsgemässen elektrischen Systems ermöglicht.

### Bezugszeichenliste

- 1: Halbleiterstapelverband
- 2: Deckenteil
- 3: Bodenteil
- 4: erstes Seitenteil
- 5: zweites Seitenteil
- 6: Einspanneinrichtung
- 7: Ansteuereinheit .
- 8: Beschaltung

## Patentansprüche

1. Haltevorrichtung für mindestens einen Halbleiterstapelverband (1), die aus einem Deckenteil (2), einem Bodenteil (3) und einem ersten Seitenteil (4) und einem zweiten Seitenteil (5) aufgebaut ist, wobei der Deckenteil (2) über das erste und zweite Seitenteil (4, 5) mit dem Bodenteil (3) verbindbar ausgebildet ist und der oder jeder Halbleiterstapelverband (1) zwischen dem Deckenteil (2) und dem Bodenteil (3) eingespannt ist, **dadurch gekennzeichnet,**
**dass** das erste Seitenteil (4) und das zweite Seitenteil (5) jeweils berührungslos von dem oder jedem Halbleiterstapelverband (1) beabstandet ist.

2. Haltevorrichtung nach Anspruch 1, **dadurch gekennzeichnet, dass** das erste und zweite Seitenteil (4, 5) jeweils plattenförmig ausgebildet ist.

3. Haltevorrichtung nach Anspruch 1 oder 2, **dadurch gekennzeichnet, dass** das erste und zweite Seitenteil (4, 5) ein Isolationsmaterial enthält.

4. Haltevorrichtung nach einem der vorhergehenden Ansprüche, **dadurch gekennzeichnet, dass** die erste Seitenplatte (4) und/oder die zweite Seitenplatte (5) als Befestigungseinheit zur Befestigung einer Ansteuereinheit (7) des Halbleiterstapelverbandes (1) und/oder einer Beschaltung (8) des Halbleiterstapelverbandes (1) ausgebildet ist.

5. Haltevorrichtung nach einem der vorhergehenden Ansprüche, **dadurch gekennzeichnet, dass** zur Einspannung des jeweiligen Halbleiterstapelverbandes (1) eine Einspanneinrichtung (6) zwischen dem Deckenteil (2) und dem jeweiligen Halbleiterstapelverband (1) angeordnet ist.

6. Haltevorrichtung nach Anspruch 5, **dadurch gekennzeichnet, dass** Einspanneinrichtung (6) als Feder ausgebildet ist.

7. Elektrisches System mit mindestens zwei Haltevorrichtungen nach einem der Ansprüche 1 bis 7, **dadurch gekennzeichnet, dass** die Haltevorrichtungen nebeneinander angeordnet sind.

8. Elektrisches System mit mindestens zwei Haltevorrichtungen nach einem der Ansprüche 1 bis 7, **dadurch gekennzeichnet, dass** die Haltevorrichtungen übereinander angeordnet sind.
